# EUROPEAN PATENT APPLICATION

(11) **EP 4 788 095 A1**
(43) Date of publication of application: **05.08.2026**
(21) Application number: 26151335.2
(22) Date of filing: 12.01.2026
(51) Int. Cl.: H10F 77/20, H10F 19/33, H10F 19/35

(54) **PHOTOELECTRIC CONVERSION ELEMENT AND METHOD FOR MANUFACTURING PHOTOELECTRIC CONVERSION ELEMENT**

(30) Priority: 31.01.2025 JP 2025014894
(71) Applicant: Enecoat Technologies Co., Ltd., Kyoto 613-0031 (JP); Toyota Jidosha Kabushiki Kaisha, Toyota-shi, Aichi-ken 471-8571 (JP)
(72) Inventor: TAKAHAMA, Tsuyoshi, Kuse-gun, Kyoto, 613-0031 (JP); KANEKO, Ryuji, Kuse-gun, Kyoto, 613-0031 (JP); OKUMURA, Kenichi, Toyota-shi, 471-8571 (JP); HOMBE, Atsushi, Toyota-shi, 471-8571 (JP)
(74) Representative: Kuhnen & Wacker Patent- und Rechtsanwaltsbüro PartG mbB

(57) **Abstract**

A photoelectric conversion element and a method for manufacturing the photoelectric conversion element capable of suppressing an increase in internal resistance are provided. A photoelectric conversion element (1) according to the present disclosure includes a first transparent electrode layer (12) that is disposed on a substrate, a photoelectric conversion layer (13) positioned on the first transparent electrode layer (12), a second transparent electrode layer (14) positioned on the photoelectric conversion layer (13), and a conductor part (15). Detailed configurations of the first transparent electrode layer (12), the photoelectric conversion layer (13), the second transparent electrode layer (14), and the conductor part (15) are described in the specification.

## Description

### BACKGROUND

The present disclosure relates to a photoelectric conversion element and a method for manufacturing a photoelectric conversion element.

Patent Literature 1 discloses a photoelectric conversion device. The photoelectric conversion device disclosed in Patent Literature 1 includes a first conductive layer, a photoelectric conversion layer disposed on the first conductive layer, and a transparent second conductive layer disposed on the photoelectric conversion layer. The photoelectric conversion device disclosed in Patent Literature 1 includes an area where the first conductive layer contacts the second conductive layer.

[Patent Literature 1] Japanese Unexamined Patent Application Publication No. 2013-045965

### SUMMARY

Incidentally, in recent years, tandem solar cells that improve photoelectric conversion efficiency by stacking two photoelectric conversion elements have been known. In the tandem solar cells, the photoelectric conversion element arranged on a light incident side, that is, a front surface, needs to allow light that has not been absorbed to transmit toward a back surface.

In the aforementioned photoelectric conversion elements, it is required to configure electrode layers on the both surfaces as transparent electrode layers in order to allow light to transmit therethrough. In general, transparent electrode layers have higher electrical resistance compared to non-transparent electrode layers, which causes a problem that internal resistance increases in the aforementioned light-transmissive photoelectric conversion elements.

It may be possible to suppress an increase in the internal resistance by increasing the thickness of the transparent electrode layers. However, increasing the thickness of the transparent electrode layers is not preferable because it causes a decrease in the light transmittance. Further, the thickness of the transparent electrode layers needs to be determined taken into consideration the interference of light inside the transparent electrode layer, and cannot be easily adjusted.

The present disclosure has been made in order to solve the aforementioned problem, and an object of the present disclosure is to provide a photoelectric conversion element and a method for manufacturing a photoelectric conversion element capable of suppressing an increase in internal resistance.

A photoelectric conversion element according to the present disclosure is a photoelectric conversion element including: a first transparent electrode layer that is disposed on a substrate, a photoelectric conversion layer that is disposed on the first transparent electrode layer, and a second transparent electrode layer that is disposed on the photoelectric conversion layer. The first transparent electrode layer is separated by a first groove structure that extends to be substantially parallel to a first direction, and the photoelectric conversion layer and the second transparent electrode layer are separated by a second groove structure that extends to be substantially parallel to the first direction. The photoelectric conversion element according to the present disclosure further includes a third groove structure that is provided in the photoelectric conversion layer and the second transparent electrode layer and extends to be substantially parallel to a second direction that is perpendicular to the first direction while being branched off from the second groove structure. The photoelectric conversion element according to the present disclosure further includes a conductor part having one end side that is electrically connected to the second transparent electrode layer and another end side that extends to be electrically connected to the first transparent electrode layer in the third groove structure, the conductor part having conductivity higher than that of the first transparent electrode layer and the second transparent electrode layer.

In the photoelectric conversion element according to the present disclosure, one end side of each of the conductor parts may at least extend to an intermediate position of one of the second transparent electrode layers separated by the second groove structure in a second direction, and the other end side may extend to at least an intermediate position of the first transparent electrode layer in the second direction via the third groove structure.

In the photoelectric conversion element according to the present disclosure, one end side of each of the conductor parts and a plurality of the third groove structures may be alternately arranged in the first direction on one of the second transparent electrode layers separated by the second groove structure.

In the photoelectric conversion element according to the present disclosure, when a length in the second direction of the conductor part that is electrically connected to the second transparent electrode layer is denoted by L1 and a length of the entire conductor part in the second direction is denoted by L3, a relation 1.2 ≤ L1/L3 may be satisfied. A length L2 in the first direction from the conductor part to the third groove structure may be 20 mm or less.

In a method for manufacturing a photoelectric conversion element according to the present disclosure, first, a substrate including a first transparent electrode layer is prepared. Next, a first groove structure that extends to be substantially parallel to a first direction is formed in the first transparent electrode layer. Next, a photoelectric conversion layer is formed on the first transparent electrode layer. Next, a second transparent electrode layer is formed on the photoelectric conversion layer. Next, a second groove structure that extends to be substantially parallel to a first direction is formed in the photoelectric conversion layer and the second transparent electrode layer. Next, a third groove structure that extends to be substantially parallel to a second direction that is perpendicular to the first direction while being branched off from the second groove structure is formed. Last, a conductor part having one end side that is electrically connected to the second transparent electrode layer and another end side that extends to be electrically connected to the first transparent electrode layer in the third groove structure, the conductor part having conductivity higher than that of the first transparent electrode layer and the second transparent electrode layer, is formed.

According to the present disclosure, it is possible to provide a photoelectric conversion element and a method for manufacturing the photoelectric conversion element capable of suppressing an increase in internal resistance.

The above and other objects, features and advantages of the present disclosure will become more fully understood from the detailed description given hereinbelow and the accompanying drawings.

### BRIEF DESCRIPTION OF DRAWINGS

Fig. 1 is a schematic cross-sectional diagram showing a configuration of a photoelectric conversion element according to a first embodiment;
Fig. 2 is a schematic overview diagram showing a configuration of the photoelectric conversion element according to the first embodiment;
Fig. 3 is a schematic overview diagram showing a configuration of the photoelectric conversion element according to the first embodiment;

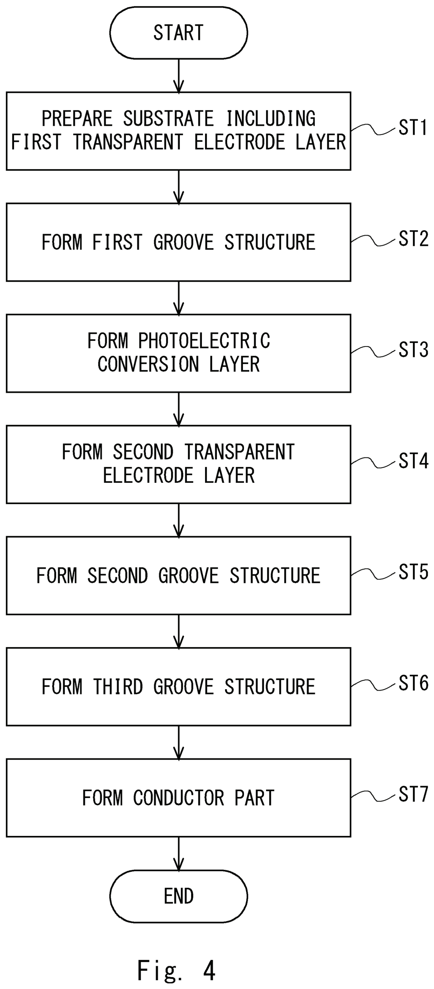

Fig. 4 is a flowchart showing a method for manufacturing the photoelectric conversion element according to the first embodiment; and
Fig. 5 is a schematic cross-sectional diagram showing a configuration of a tandem solar cell according to another embodiment.

### DESCRIPTION OF EMBODIMENTS

### <First Embodiment>

### (Configuration of Photoelectric Conversion Element)

Hereinafter, with reference to the drawings, a first embodiment according to the present disclosure will be described in detail. First, a configuration of a photoelectric conversion element according to this embodiment will be described in detail.

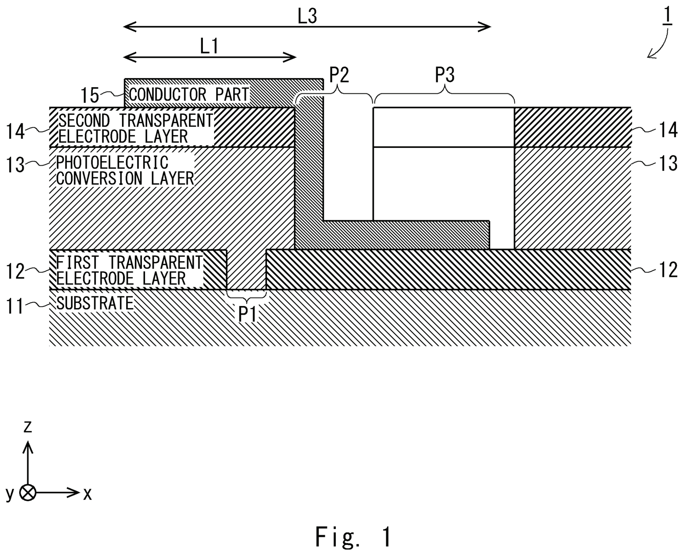

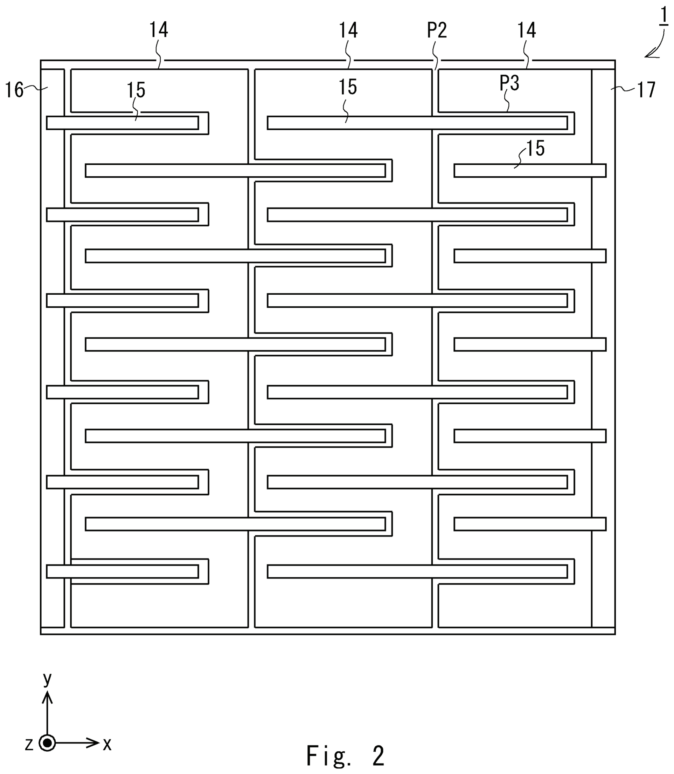

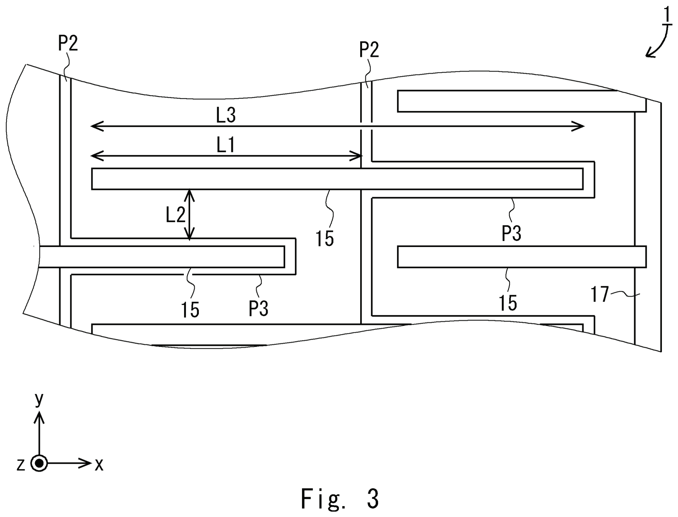

Figs. 1, 2, and 3 are schematic diagrams for describing a configuration of a photoelectric conversion element according to a first embodiment. More specifically, Fig. 1 is a schematic cross-sectional diagram showing the configuration of the photoelectric conversion element according to the first embodiment, Fig. 2 is a schematic overview diagram showing a configuration of the photoelectric conversion element according to the first embodiment, and Fig. 3 is a schematic overview diagram in which a part of the schematic overview diagram shown in Fig. 2 is enlarged.

As a matter of course, right-handed xyz orthogonal coordinates shown in Fig. 1 and the other drawings are indicated for convenience to describe the positional relationship of the components. The y-axis direction may be herein referred to as a first direction and the x-axis direction that is perpendicular to the y-axis may be herein referred to as a second direction.

The photoelectric conversion element according to this embodiment is a light-transmissive photoelectric conversion element. That is, the photoelectric conversion element according to this embodiment converts light that is made incident from one of a z-axis positive direction or a z-axis negative direction into electric power. In the photoelectric conversion element according to this embodiment, light that has not been converted into electric power is transmitted toward a side opposite to the side on which the light is made incident along an incident direction.

The photoelectric conversion element according to this embodiment may be used, for example, as an upper cell or a middle cell of a tandem solar cell.
Further, the photoelectric conversion element according to this embodiment may be used, for example, for solar cells also used as window glass of a building.

As shown in Fig. 1, the photoelectric conversion element according to this embodiment includes a substrate 11, a first transparent electrode layer 12, a photoelectric conversion layer 13, a second transparent electrode layer 14, a conductor part 15, a first end conductor part 16, and a second end conductor part 17.

As shown in Fig. 1, the photoelectric conversion element 1 according to this embodiment includes the substrate 11, the first transparent electrode layer 12, the photoelectric conversion layer 13, and the second transparent electrode layer 14 in this order.

While the details will be described later, as shown in Fig. 2, in the photoelectric conversion element 1 according to this embodiment, the second transparent electrode layer 14 is divided into three parts by a second groove structure P2. Further, as shown in Fig. 2, the photoelectric conversion element 1 according to this embodiment includes 22 conductor parts 15, and the first end conductor part 16 and the second end conductor part 17 on the respective ends of the conductor parts 15.

The above numbers are merely examples, and they may be changed as appropriate.

The photoelectric conversion layer 13 is a layer that is positioned between the first transparent electrode layer 12 and the second transparent electrode layer 14 that will be described later. The photoelectric conversion layer 13 excites electrons by absorbing the incident light, thereby generating holes and conduction electrons.

The holes and the conduction electrons generated in the photoelectric conversion layer 13 are each energized in one of the first transparent electrode layer 12 or the second transparent electrode layer 14.

As shown in Fig. 1, the photoelectric conversion layer 13 is separated into a plurality of sections by the second groove structure P2. Further, a third groove structure P3 is formed in the photoelectric conversion layer 13.

As shown in Figs. 1, 2, and 3, the second groove structure P2, which is a linear groove that extends in the y-axis direction, that is, substantially parallel to the first direction, separates the photoelectric conversion layer 13 and the second transparent electrode layer 14. Further, as shown in Figs. 1, 2, and 3, the third groove structure P3, which is a linear groove that is formed in the photoelectric conversion layer 13 and the second transparent electrode layer 14, branches off from the second groove structure P2 and extends in the x-axis direction, that is, substantially parallel to the second direction.

The expression "substantially parallel" includes not only a case in which components are strictly "parallel" to each other but also a case in which components are "parallel" to each other with some deviations within the scope of the present application.

The photoelectric conversion layer 13 according to this embodiment may include, for example, perovskite compounds as one of main components. That is, the photoelectric conversion element 1 according to this embodiment may be a perovskite solar cell.

The term "perovskite compounds" indicates a compound group that may have a perovskite-type crystal structure.

In the above case, the photoelectric conversion layer 13 according to this embodiment includes a perovskite layer containing perovskite compounds as a main component, a hole transport layer that transports holes generated in the perovskite layer, and an electron transport layer that transports conduction electrons generated in the perovskite layer.

That is, the photoelectric conversion layer 13 according to this embodiment may not be necessarily formed of a single layer. In other words, the photoelectric conversion layer 13 according to this embodiment may be used as a general term for a plurality of layers provided between the first transparent electrode layer 12 and the second transparent electrode layer 14.

Examples of the compound that can be used as the main component of the photoelectric conversion layer 13 according to this embodiment include a compound represented by the following formula (I).

X_{α}Y_{β}Z_{γ} (I)

In the formula (I), the ratio of α:β:γ is, for example, 3:1:1, where X represents a halogen ion, Y represents a monovalent cation, and Z represents a divalent cation. The perovskite layer is preferably disposed adjacent to the electron transport layer. The ratio of α:β:γ does not necessarily need to be 3:1:1, and can be, for example, 3:1.05:0.95 or 3:0.95:1.05. The ratio of α:β:γ is, for example, 3:(0.95-1.05):(0.95-1.05).

X in the formula (I) may be, for example, halide ions such as chlorine, bromine, and iodine. One type of the halogen ions may be used alone or two or more types of them may be used in combination.

Examples of Y in the formula (I) include not only alkylamine compound ions (organic compounds having an amino group) or organic chemical species such as a methylammonium cation, an ethylammonium cation, an n-butyl ammonium cation, a formamidinium cation, and the like, but also alkali metal ions such as a cesium cation, a potassium cation, a rubidium cation, and the like. One type of the alkylamine compound ions may be used alone or two or more types of them may be used in combination. One type of the alkali metal ions may be used alone or two or more types of them may be used in combination. Further, organic chemical species (alkylamine compound ion) and inorganic chemical species (alkali metal ion) may used in combination, and, for example, cesium ion and formamidine may be used in combination.

Examples of Z in the formula (I) may be divalent metal ions such as lead, indium, antimony, tin, copper, bismuth, or germanium. One type of the divalent metal ions may be used alone or two or more types of them may be used in combination. The divalent metal ions are preferably lead, and particularly preferably the combination of lead with tin.

As described above, the photoelectric conversion layer 13 may be formed of a perovskite compound. The method for forming the perovskite layer is not particularly limited, and can be appropriately selected according to the purpose. For example, a method in which a solution in which a metal halide and an alkylamine halide are dissolved or dispersed is applied and then dried can be employed.

Further, other methods for forming the perovskite layer include, for example, a two-step precipitation method of applying and drying a solution in which a metal halide is dissolved or dispersed, and then performing immersion in a solution in which an alkylamine halide is dissolved to form a perovskite compound.

Other methods for forming the perovskite layer include, for example, a method of adding a poor solvent (a solvent having a low degree of solubility) for the perovskite compound while applying a solution in which a metal halide and an alkylamine halide are dissolved or dispersed to precipitate crystals.

In the method for precipitating crystals by adding the poor solvent, examples of the poor solvent include hydrocarbons such as n-hexane, n-octane, and the like; alcohols such as methanol, ethanol, 2-propanol, and the like; ethers such as diethyl ether, diisopropyl ether, and the like; ketones such as acetone, methyl isobutyl ketone, and the like; esters such as ethyl acetate, isobutyl acetate, γ-butyrolactone, and the like; nitriles such as acetonitrile, 3-methoxypropionitrile, and the like; aromatic hydrocarbon compounds such as benzene, toluene, chlorobenzene, and the like; halogen-based solvents such as dichloromethane, chloroform, and the like; and fluorine-based solvents such as chlorofluorocarbon, hydrochlorofluorocarbon, hydrofluorocarbon, and the like.

Other methods for forming the perovskite layer include, for example, a method of vapor depositing metal halides in a gas filled with methylamine or the like.

Further, in order to appropriately adjust the particle size of the crystals of the perovskite compound forming the perovskite layer, the method for forming the perovskite layer is particularly preferably a method of adding a poor solvent for the perovskite compound while applying a solution in which a metal halide and an alkylamine halide are dissolved or dispersed to precipitate crystals.

The method for applying the solutions is not particularly limited and can be appropriately selected according to the purpose, and examples thereof include immersing, spin coating, spraying, dipping, a method using a roller, and a method using an air knife. As a method for applying the solution, for example, a method of performing precipitation in a supercritical fluid using carbon dioxide or the like may be employed.

The method for forming the perovskite layer may further include, for example, a process for removing the solvent after the perovskite layer is formed (solvent removing process) or a process for arranging perovskite crystals (crystal arrangement process). The solvent removing process and the crystal arrangement process may include, for example, a method of blowing dry air, or the like, a method of performing heating treatment by using a hot plate, an oven, or the like, vacuum drying, and the like. In the solvent removing process and the crystal arrangement process, the heating temperature is, for example, preferably 50 to 200°C, and more preferably 70 to 180°C.

In the solvent removing process and the crystal arrangement process, the heating time is, for example, preferably 1 to 150 minutes, and more preferably 5 to 60 minutes. Further, the thickness of the photoelectric conversion layer 13 is, for example, but not particularly limited to, preferably 50 to 1500 nm, and more preferably 200 to 1000 nm, from the viewpoint of further suppressing performance degradation due to imperfections and peeling.

The method for forming the perovskite layer may include, for example, a process for performing surface treatment using salts formed of one or more cations and one or more anions (surface treatment process).

Examples of the cation may include, for example, an inorganic cation such as lithium, sodium, potassium, rubidium, cesium, magnesium, calcium, and the like; an organic cation having an amino group, such as an ammonium cation, methylamine, ethylamine, n-butylamine, isopentylamine, neopentylamine, formamidine, acetamidine, benzylamine, 2-phenylethylamine, 2-(4-methoxyphenyl)ethylamine, 4-fluorobenzylamine, 2-(4-fluorophenyl)ethylamine, 1,4-phenylenediamine, 5-aminovaleric acid, methanediamine, ethylenediamine, p-xylylenediamine, m-xylylenediamine, 1,2-adamantanediamine, 1,3-adamantanediamine, N,N-dimethylethylenediamine, 1,3-diaminopropane, 1,4-diazabicyclo[2.2.2]octane, guanidine, aniline, pyrrole, imidazole, 1-ethylimidazole, 2-ethylimidazole, benzimidazole, morpholine, pyrrolidine, pyrazole, triazole, carbazole, and the like; a cation obtained from a heterocycle or the like containing nitrogen atoms such as pyridine, pyrazine, pyridazine, pyrimidine, quinoline, isoquinoline, phenanthroline, 2,2'-bipyridyl, or 4,4'-bipyridyl, and the like.

Examples of the anion include a halogen ion such as a fluorine ion, a chlorine ion, a bromine ion, or an iodine ion; a carboxylic acid ion such as a formate ion or an acetate ion; an isocyanate ion, a thiocyanate ion, a tetrafluoroborate ion, a hexafluorophosphate ion; a trifluoromethanesulfonylimide ion, and the like.

The salt consisting of the cation and the anion is preferably dissolved, for example, into one or more types of solvents.

Examples of the solvent may be alcohols such as isopropanol (2-propanol), ethanol (EtOH), methanol (MeOH), n-butanol, and the like; nitriles such as acetonitrile, propionitrile and the like; aromatic-based solvents such as toluene, chlorobenzene, 1,2-dichlorobenzene, and the like. As the solvent, for example, one type of them may be used alone or two or more types of them may be used in combination.

The surface treatment process is performed by applying a solution in which the salt is dissolved onto the formed perovskite layer and drying the solution.

The method for applying the solutions is not particularly limited and can be appropriately selected according to the purpose, and examples thereof include immersing, spin coating, spraying, dipping, a method using a roller, and a method using an air knife.

In the surface treatment process, heating treatment may be performed after the solution is applied. When heating is performed, the heating temperature is, for example, preferably 50 to 200°C, and more preferably 70 to 180°C. The heating time is, for example, preferably 1 to 150 minutes, and more preferably 5 to 60 minutes. The thickness of the film to which the solution is applied is not particularly limited.

Examples of compounds that can be used as main components of the hole transport layer include an inorganic hole transport material or an organic hole transport material.

Examples of the inorganic hole transport material include a compound semiconductor including a monovalent copper such as CuI, CuInSe₂, or CuS; a compound including metal other than copper, such as GaP, NiO, FeO, Bi₂O₃, MoO₃, or Cr₂O, and the like. In order to receive only holes more efficiently and obtain higher hole mobility, the inorganic hole transport material is preferably a semiconductor including monovalent copper, and more preferably CuI or CuSCN. Examples of the organic hole transport material include polythiophene derivatives such as poly-3-hexylthiophene (P3HT) or polyethylenedioxythiophene (PEDOT); fluorene derivatives such as 2,2',7,7'-tetrakis-(N,N-di-p-methoxyphenylamino)-9,9'-spirobifluorene (Spiro-OMeTAD); carbazole derivatives such as polyvinylcarbazol; triphenylamine derivatives such as poly[bis(4-phenyl)(2,4,6-trimethylphenyl)amine] (PTAA); diphenylamine derivatives; polysilane derivatives; polyaniline derivatives, and the like. In order to receive only holes more efficiently and obtain higher hole mobility, the organic hole transport material is preferably triphenylamine derivatives, fluorene derivatives, and the like, and more preferably PTAA, Spiro-OMeTAD, and the like.

In order to further improve the hole transport characteristics, the organic hole transport material may include, for example, oxidant of lithium bis(trifluoromethanesulfonyl)imide (LiTFSI), silver bis(trifluoromethanesulfonyl)imide, zinc bis(trifluoromethanesulfonyl)imide, ammoniumbis(trifluoromethanesulfonyl)imide, lithium bis(nonafluoro butane sulfonyl)imide, sodium bis(nonafluoro butane sulfonyl imide), lithium nonafluoro-N-[(trifluoromethane)sulfonyl]butane sulfonyl imide, potassiumnonafluoro-N-[(trifluoromethane)sulfonyl]butane sulfonyl imide, nonafluoro-N-[(trifluoromethane)sulfonyl]butane sulfonyl imide, lithium N,N-hexafluoro-1,3-disulfonyl imide, sodium N,N-hexafluoro-1,3-disulfonyl imide, trifluoromethyl sulfonyloxysilver, NOSbF6, SbC15, SbF5, tris(2-1H-pyrazole-1-yl)-4-tert-butylpyridine)cobalt(III)tri[bis(trifluoromethane)sulfonimide]. Further, the hole transport layer may include, for example, basic compounds such as tert-butylpyridine (TBP), 2-picoline, 2,6-lutidine, and the like. The content of each of the oxidizing agent and the basic compounds may be, for example, an amount that has been normally used. The thickness of the hole transport layer is, for example, 1 nm-500 nm or 2 nm-300 nm in order to receive only holes more efficiently and obtain higher hole mobility.

Further, as hole transport in an inverted structure, for example, a hole transport compound for forming a monomolecular layer (hereinafter also referred to as a "monomolecular hole transport compound") may be used. It is desirable that the monomolecular hole transport compound includes, for example, anchor for chemical bonding with an ITO or the like, which is a transparent electrode, in an inverted structure. Examples of the anchor include a phosphonic acid group (-P=O(OH)₂), a carboxy group (-COOH), a sulfo group (-SO₃H), a boronic acid group (-B(OH)₂), a trihalogenated silyl group (-SiX₃, where X is a halogen atom) or a trialkoxysilyl group (-Si(OR)₃, where R is an alkyl group), or may be salts thereof. Examples of the salts include alkali-metal salts with potassium, sodium, or the like, quaternary ammonium salts with tetramethylamine, tetra-n-butylamine, or the like. Among them, a phosphonic acid group, a trihalogenated silyl group, and a trialkoxysilyl group are particularly preferable.

The monomolecular hole transport compound may include, for example, a compound represented by the formula (II).

Ar-(L-Z)n (II)

In the formula (II), Ar has a structure with an aromatic ring and optionally contains a heteroatom among atoms constituting the aromatic ring, Ar optionally has a substituent other than -L-Z, -L-Z may be one or more, and when two or more -L-Zs are present, Ls and Zs are optionally identical to or different from each other, and Ls are each an atomic group or a covalent bond that bonds Ar and Z, and Zs are each a group capable of transferring electric charges to and from the transparent electrode layer 12 (or 14). The number of -L-Zs is not particularly limited, and is, for example, 1 to 4. For example, in the formula (II), the examples of L include divalent alkylene groups such as a 1,1-methylene group and a 1,2-ethylene group; and divalent alkoxy groups such as diethoxyethane and the like, which may have or may not have a substituent other than the above Z. For example, in the formula (II), Zs may each have a phosphonic acid group (-P=O(OH)₂), a carboxy group (-COOH), a sulfo group (-SO₃H), a boronic acid group (-B(OH)₂), a trihalogenated silyl group (-SiX₃, where X is a halogen atom), or a trialkoxysilyl group (-Si(OR)₃, where R is an alkyl group).

Preferable examples of the compound that can be used as a main component of the electron transport layer include a semiconductor material. The semiconductor material is not particularly limited, and a known material can be used, and examples thereof include a single semiconductor, a compound semiconductor, and an organic n-type semiconductor. The single semiconductor is not particularly limited, and examples thereof include silicon and germanium.
The compound semiconductor is not particularly limited and examples thereof include metal chalcogenides, specifically oxides of titanium, tin, zinc, iron, tungsten, zirconium, hafnium, strontium, indium, cerium, yttrium, lanthanum, vanadium, niobium, tantalum, and the like; sulfides of cadmium, zinc, lead, silver, antimony, bismuth, and the like; selenides of cadmium, lead, and the like; and tellurides of cadmium, and the like. Examples of the other compound semiconductor include phosphides of zinc, gallium, indium, cadmium, and the like; gallium arsenide; copper-indium-selenide; copper-indium-sulfide, and the like. The organic n-type semiconductor is not particularly limited and examples thereof include a perylenetetracarboxylic anhydride; a perylenetetracarboxydiimide compound; a naphthalene diimide-bithiophene copolymer; a benzobisimidazobenzophenanthroline polymer; fullerene compounds such as C₆₀, C₇₀, PCBM ([6,6]-phenyl-C₆₁-butyrate methyl ester), and the like; a carbonyl bridge-bithiazole compound; ALq₃(tris(8-quinolinolato)aluminum), a triphenylenebipyridyl compound; a silol compound; and an oxadiazole compound.

Note that the photoelectric conversion element according to the present disclosure is not limited to the perovskite-type one, and may be, for example, a CIS-type, cuprous oxide type, or amorphous silicon-type photoelectric conversion element. That is, while the configuration of the photoelectric conversion element according to the present disclosure can be applied to any photoelectric conversion element, the photoelectric conversion element is preferably applied to a thin-film photoelectric conversion element from the viewpoint of light transmittance.

Further, the configuration of the photoelectric conversion layer according to the present disclosure is appropriately changed according to the type of the photoelectric conversion element to be applied. The configuration of the photoelectric conversion layer according to the present disclosure may be any one as long as the photoelectric conversion layer can allow electrons to excite by absorbing incident light and to allow light that has not been used to excite electrons to transmit therethrough.

The first transparent electrode layer 12, which is a layer that is disposed on the substrate 11, has conductivity and light transmittance. The first transparent electrode layer 12 conducts electric charges generated in the photoelectric conversion layer 13.

As shown in Fig. 1, the first transparent electrode layer 12 is separated into a plurality of sections by the first groove structure P1. Note that the first groove structure P1, which is a linear groove formed in the first transparent electrode layer 12, extends to be substantially parallel to the first direction.

The first transparent electrode layer 12 typically includes tin-doped indium oxide (ITO), impurity-doped indium oxide (In₂O₃), impurity-doped zinc oxide (ZnO), fluorine-doped tin dioxide (FTO), gold, silver, copper, aluminum, tungsten, titanium, chromium, nickel, cobalt, graphene, metal nanowires, or the like as main components. One type of these main components may be used alone or two or more types of them may be used in combination.

Further, the first transparent electrode layer 12 may have a single layer or may be a plurality of layers. When the first transparent electrode layer 12 includes a plurality of layers, some of the layers included in the first transparent electrode layer 12 may function as anti-diffusion layers.

Note that the first transparent electrode layer 12 may be used in combination with a metal wiring or the like. The material for the metal wiring is not particularly limited, and examples thereof include aluminum, copper, silver, gold, platinum, and nickel.

Further, the first transparent electrode layer 12 may be formed as a film having a uniform thickness or may be a mesh-shaped film.

The second transparent electrode layer 14, which is a layer that is disposed on the photoelectric conversion layer 13, has conductivity and light transmittance. The second transparent electrode layer 14 collects electric charges generated in the photoelectric conversion layer 13.

The second transparent electrode layer 14 typically includes tin-doped indium oxide (ITO, Indium Tin Oxide), zinc-doped indium oxide (IZO, Indium Zinc Oxide), impurity-doped zinc oxide (ZnO, Zinc Oxide), fluorine-doped tin dioxide (FTO, F-doped Tin Oxide), antimony-doped tin oxide (ATO), or the like as main components.

Note that the first transparent electrode layer 12 and the second transparent electrode layer 14 may be formed of the same material or may be formed of different materials.

The thickness of each of the first transparent electrode layer 12 and the second transparent electrode layer 14 is preferably 50 nm to 100 nm, and further preferably 60 nm to 80 nm from the viewpoint of suppressing a reduction in the transmittance due to light interference. When the thickness falls within the aforementioned range, the sheet resistance becomes larger, i.e., 20 Ω/□ to 40 Ω/□ (per unit area) than the sheet resistance of ITO 10 Ω/□ to 20 Ω/□ when the thickness is 150 nm to 200 nm, which is a thickness according to conventional art. However, since a conductor part that will be described later is provided in the photoelectric conversion element according to the present disclosure, the loss of the resistive component of the transparent electrode layer can be substantially reduced by half.

The first transparent electrode layer 12 and the second transparent electrode layer 14 are electrically connected to each other via the conductor part 15. More specifically, in the photoelectric conversion element 1 according to this embodiment, the first transparent electrode layer 12 separated by the first groove structure P1 and the second transparent electrode layer 14 separated by the second groove structure P2 are electrically connected in series. That is, the photoelectric conversion element 1 according to this embodiment has a configuration as an integrated photoelectric conversion element.

The conductor part 15, which is a linear member having conductivity higher than that of the first transparent electrode layer 12 and the second transparent electrode layer 14, may be formed of, for example, metal materials with low volume resistivity.

The conductor part 15 extends in such a way that one end side thereof is electrically connected to the second transparent electrode layer 14 and the other end side thereof is electrically connected to the first transparent electrode layer 12 in the third groove structure P3. In other words, the conductor part 15 extends from one point on the second transparent electrode layer 14 to one point on the first transparent electrode layer 12 while crossing over the first groove structure P1.

The conductor part 15 is formed by applying metal (silver, copper, aluminum, tin, nickel, gold, or the like) paste by using a screen printing machine. While the metal paste is preferably silver paste from the viewpoint of the performance and the manufacturing, it may be paste of copper, aluminum, tin, nickel, gold, or the like. Alternatively, the metal paste may be formed by a vacuum deposition method by masking.

The conductor part 15 electrically connects the first transparent electrode layer 12 to the second transparent electrode layer 14. That is, the conductor part 15 functions in such a way that a current collecting effect is exerted so that the shortest flow path of the current flowing in a direction from the first transparent electrode layer 12 to the second transparent electrode layer 14 or in the opposite direction is formed. That is, the conductor part 15 collects electric charges that flow through the first transparent electrode layer 12 and the second transparent electrode layer 14, whereby conductivity is supplemented by the conductor part 15, the thickness of each of the first transparent electrode layer 12 and the second transparent electrode layer 14 can be reduced, and the light transmittance can be increased. As a result, it may be possible to secure efficiency of extracting electric charges and improve light transmittance in the first transparent electrode layer 12 and the second transparent electrode layer 14.

Note that one end side of the conductor part 15 preferably extends at least to an intermediate position of one of the second transparent electrode layers 14 separated by the second groove structure P2 when viewed from the second direction, and the other end side of the conductor part 15 preferably extends at least to an intermediate position of the first transparent electrode layer 12 when viewed from the second direction via the third groove structure P3.

According to the above-described configuration, it is possible to sufficiently secure the area where the conductor part 15 contacts the first transparent electrode layer 12 and the second transparent electrode layer 14. As a result, the photoelectric conversion element 1 according to this embodiment can further suppress an increase in the internal resistance.

Further, as shown in Figs. 1 and 3, when the length of the conductor part 15 in the second direction that is electrically connected to the second transparent electrode layer 14 is denoted by L1 and the length of the entire conductor part 15 in the second direction is denoted by L3, a relation 1.2 ≤ L1/L3 is preferably satisfied.

According to the above-described configuration, the area where the conductor part 15 contacts the second transparent electrode layer 14 can be sufficiently secured. As a result, the photoelectric conversion element 1 according to this embodiment can further suppress an increase in the internal resistance.

When the length in the first direction from the plurality of conductor parts to the plurality of third groove structures P3 is denoted by L2, L2 is preferably 20 mm or less, and preferably 5 mm or more and 10 mm or less.

According to the above-described configuration, it is possible to obtain a current collecting effect by the conductor part 15 in the second transparent conductive layer 14 while reducing the area occupied by the conductor part 15 having a low light transmittance. As a result, the groove structure P3 according to this embodiment can definitely suppress a substantial increase in the internal resistance.

Further, as shown in Fig. 2, the photoelectric conversion element 1 according to this embodiment includes a plurality of conductor parts 15 and a plurality of third groove structures P3 on the second transparent electrode layer 14 in one section separated by the second groove structure P2. Then, as shown in Fig. 2, the plurality of conductor parts 15 and the plurality of third groove structures P3 are alternately arranged on the second transparent electrode layer 14 in one section.

According to the above-described configuration, the photoelectric conversion element 1 according to this embodiment can disperse the path of the current. As a result, the photoelectric conversion element 1 according to this embodiment can disperse electric charges in the photoelectric conversion element 1.

The first end conductor part 16 and the second end conductor part 17 shown in Fig. 2 are linear members arranged in the respective ends of the photoelectric conversion element 1. The first end conductor part 16 and the second end conductor part 17 have conductivity higher than that of the first transparent electrode layer and the second transparent electrode layer. The first end conductor part 16 and the second end conductor part 17 are preferably made of a material similar to that of the conductor part 15 from the viewpoint of reducing the manufacturing cost.

As shown in Fig. 2, the first end conductor part 16 is disposed on the surface of the substrate 11 along the first direction on one end side of the photoelectric conversion element 1 in the second direction, is electrically connected to one end side of each of the conductor parts 15, and is separated from an adjacent second transparent electrode layer 14.

Further, as shown in Fig. 2, the second end conductor part 17 is a linear member that is disposed on the end of the second transparent electrode layer 14 along the first direction on the other end side of the photoelectric conversion element 1 in the second direction and is electrically connected to the other end side of each of the conductor parts 15. The first end conductor part 16 and the second end conductor part 17 can be used as a pair of power-extraction terminals of the photoelectric conversion element 1.

Note that, in the photoelectric conversion element according to the present disclosure, the first end conductor part 16 and the second end conductor part 17 may not be necessarily provided. In other words, in the photoelectric conversion element according to the present disclosure, the configuration of the end part is not particularly limited.

As described above, the photoelectric conversion element according to this embodiment connects the first transparent electrode layer to the second transparent electrode via the conductor part 15 having the above-described configuration. According to this configuration, the photoelectric conversion element according to this embodiment is provided with the transparent electrode layers 12 and 14 having reduced thickness on both front and back surfaces, whereby it is possible to increase the light transmittance and suppresses a substantial increase in the internal resistance of the photoelectric conversion element by the conductor part 15.

### (Method for manufacturing Photoelectric Conversion Element)

Next, a method for manufacturing the photoelectric conversion element according to this embodiment will be described in detail. Fig. 3 is a flowchart showing the method for manufacturing the photoelectric conversion element according to the first embodiment.

In the method for manufacturing the photoelectric conversion element according to this embodiment, first, a substrate including a first transparent electrode layer is prepared (Step ST1). That is, in Step ST1, a substrate 11 including a first transparent electrode layer 12 on its principal surface is prepared.

The Step ST1 may be a process for forming the first transparent electrode layer 12 on the substrate 11, or may be a process for preparing a commercially available transparent electrode substrate.

In the method for manufacturing the photoelectric conversion element according to this embodiment, next, a first groove structure is formed (Step ST2). That is, in Step ST2, the first groove structure P1 is formed in the first transparent electrode layer 12, whereby the first transparent electrode layer 12 is divided.

Note that the method for forming the first groove structure P1 may be a known method such as a laser etching method or a wet etching method. The method for forming the first groove structure P1 can be selected as appropriate depending on the materials of the substrate 11 and the first transparent electrode layer 12.

In the method for manufacturing the photoelectric conversion element according to this embodiment, next, a photoelectric conversion layer is formed (Step ST3). That is, in Step ST3, the photoelectric conversion layer 13 is formed on the first transparent electrode layer 12.

As a method for forming the photoelectric conversion layer 13, for example, an ink jet method, a spray coating method, a die coating method, a spin coating method, a vacuum deposition method, or the like may be appropriately used.

When the photoelectric conversion layer 13 includes a plurality of layers, the method for forming the plurality of layers may be the same or may be different from one another.

In the method for manufacturing the photoelectric conversion element according to this embodiment, next, a second transparent electrode layer is formed (Step ST4). That is, in Step ST4, a second transparent electrode layer 14 is formed on the photoelectric conversion layer 13.

Although the second transparent electrode layer 14 can be formed by using a sputtering method or a CVD method, it can also be formed by using a spray coating method, a die coating method, a spin coating method, a vacuum deposition method, or the like as appropriate.

In the method for manufacturing the photoelectric conversion element according to this embodiment, next, a second groove structure is formed (Step ST5). That is, in Step ST5, a second groove structure P2 is formed in the photoelectric conversion layer 13 and the second transparent electrode layer 14, thereby separating the photoelectric conversion layer 13 and the second transparent electrode layer 14.

In the method for manufacturing the photoelectric conversion element according to this embodiment, next, a third groove structure is formed (Step ST6). That is, in Step ST6, a third groove structure P3 is formed in the photoelectric conversion layer 13 and the second transparent electrode layer 14.

Note that the second groove structure P2 and the third groove structure P3 are preferably formed by laser etching. Another known method such as a wet etching method may also be used.

Further, since the second groove structure P2 and the third groove structure P3 are successive groove structures, they may be formed in one process.

Note that the width of each of the first groove structure P1, the second groove structure P2, and the third groove structure P3 may be appropriately formed in a range from 0.05 to 1.0 mm, preferably in a range from 0.1 to 0.5 mm.

Last, a conductor part is formed (Step ST7), whereby the method for manufacturing the photoelectric conversion element according to this embodiment is completed. That is, by forming the conductor part 15 in Step ST7, the photoelectric conversion element 1 according to this embodiment as shown in Figs. 1 and 2 is obtained.

For example, in Step ST7, the conductor part 15 may be formed by performing screen printing using metal paste or ink jet printing using metal ink from one point on the second transparent electrode layer to one point positioned in the third groove structure.

Note that the conductor part 15 can be appropriately formed to have a width dimension in a range from 0.03 to 0.5 mm, preferably a range from 0.05 to 0.3 mm.

According to the steps described above, the photoelectric conversion element 1 according to this embodiment can be manufactured.

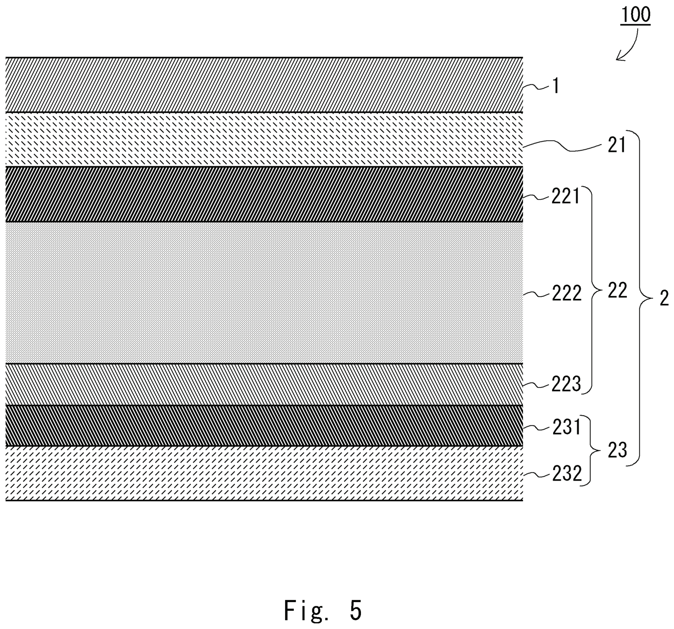

Further, as described above, the photoelectric conversion element according to the present disclosure may be used as an upper cell of a tandem solar cell. Fig. 5 is a schematic cross-sectional diagram showing a configuration of a tandem solar cell according to another embodiment.

As shown in Fig. 5, a tandem solar cell 100 according to another embodiment uses a photoelectric conversion element 1 as the upper cell and uses a second photoelectric conversion element 2 as a bottom cell. In the tandem solar cell 100 according to this embodiment, a part of light that is made incident on the photoelectric conversion element 1 transmits through the photoelectric conversion element 1 and is illuminated onto the second photoelectric conversion element 2. According to this configuration, the tandem solar cell 100 according to this embodiment can improve photoelectric conversion efficiency.

The second photoelectric conversion element 2 includes a third electrode layer 21, a silicon-containing layer 22, and a fourth electrode layer 23 in this order from the side from which the light transmitted through the photoelectric conversion element 1 is made incident, that is, from the positive side of the z-axis.

In the second photoelectric conversion element 2, layers adjacent to each other may be laminated via other components.

The silicon-containing layer 22 is a layer that is positioned in the middle of the third electrode layer 21 and the fourth electrode layer 23. The silicon-containing layer 22 excites electrons by absorbing the incident light, thereby generating holes and conduction electrons.

The silicon-containing layer 22 may be, for example, a laminate of an amorphous silicon layer and a single crystal silicon layer. As shown in Fig. 5, the silicon-containing layer 22 according to this embodiment includes an amorphous silicon layer (i/n) 221, an n-type single crystal silicon layer 222, and an amorphous silicon layer (i/p) 223 in this order from the positive side of the z-axis.

The crystal silicon may be, for example, silicon wafers obtained by slicing a silicon ingot, or silicon wafers obtained by grinding the above silicon wafers. The silicon wafer may be a single crystal or a polycrystal, and preferably a single crystal.

Further, the crystal silicon may be silicon obtained by crystallizing amorphous silicon manufactured on a substrate or may be the one that has been crystallized when it is formed by using a CVD method, a sputtering method, or the like.

The third electrode layer 21 is a transparent electrode layer, and its preferable aspect is similar to those of the first transparent electrode layer 12 and the second transparent electrode layer 14. The fourth electrode layer 23 may be, for example, a laminate. As shown in Fig. 5, the fourth electrode layer 23 according to another embodiment includes an IWO layer 231 and an Ag layer 232 in this order from the positive side of the z-axis.

While the present invention has been described in view of the aforementioned embodiments, the present invention is not limited to the configurations in the above-described embodiments. As a matter of course, the present invention includes various changes, modifications, and combinations that one skilled in the art might make within the scope of the invention as set forth in claims of the present application.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A photoelectric conversion element comprising a first transparent electrode layer (12) that is disposed on a substrate (11), a photoelectric conversion layer (13) that is disposed on the first transparent electrode layer (12), and a second transparent electrode layer (14) that is disposed on the photoelectric conversion layer (13), wherein
the first transparent electrode layer (12) is separated by a first groove structure (P1) that extends to be substantially parallel to a first direction,
the photoelectric conversion layer (13) and the second transparent electrode layer (14) are separated by a second groove structure (P2) that extends to be substantially parallel to the first direction, and
the photoelectric conversion element further comprises:
a third groove structure (P3) that is provided in the photoelectric conversion layer (13) and the second transparent electrode layer (14) and extends to be substantially parallel to a second direction that is perpendicular to the first direction while being branched off from the second groove structure (P2); and
a conductor part (15) having one end side that is electrically connected to the second transparent electrode layer (14) and another end side that extends to be electrically connected to the first transparent electrode layer (12) in the third groove structure (P3), the conductor part (15) having conductivity higher than that of the first transparent electrode layer (12) and the second transparent electrode layer (14).

2. The photoelectric conversion element according to claim 1, wherein one end side of the conductor part (15) at least extends to an intermediate position of one of the second transparent electrode layers (14) separated by the second groove structure (P2) in a second direction, and the other end side extends to at least an intermediate position of the first transparent electrode layer (12) in the second direction via the third groove structure (P3).

3. The photoelectric conversion element according to claim 2, wherein one end side of each of the conductor parts (15) and a plurality of the third groove structures (P3) are alternately arranged in the first direction on one of the second transparent electrode layers (14) separated by the second groove structure (P2).

4. The photoelectric conversion element according to claim 2, wherein
when a length in the second direction of the conductor part (15) that is electrically connected to the second transparent electrode layer (14) is denoted by L1 and a length of the entire conductor part (15) in the second direction is denoted by L3, a relation 1.2 ≤ L1/L3 is satisfied, and
a length L2 in the first direction from the conductor part (15) to the third groove structure (P3) is 20 mm or less.

5. A method for manufacturing a photoelectric conversion element comprising:
preparing a substrate (11) including a first transparent electrode layer (12);
forming, in the first transparent electrode layer (12), a first groove structure (P1) that extends to be substantially parallel to a first direction;
forming a photoelectric conversion layer (13) on the first transparent electrode layer (12);
forming a second transparent electrode layer (14) on the photoelectric conversion layer (13);
forming, in the photoelectric conversion layer (13) and the second transparent electrode layer (14), a second groove structure (P2) that extends to be substantially parallel to a first direction;
forming a third groove structure (P3) that extends to be substantially parallel to a second direction that is perpendicular to the first direction while being branched off from the second groove structure (P2); and
forming a conductor part (15) having one end side that is electrically connected to the second transparent electrode layer (14) and another end side that extends to be electrically connected to the first transparent electrode layer (12) in the third groove structure (P3), the conductor part (15) having conductivity higher than that of the first transparent electrode layer (12) and the second transparent electrode layer (14).
